# FASCICULE DE BREVET EUROPEEN

(11) **EP 0 469 988 B1**
(45) Date de publication et mention de la délivrance du brevet: **28.01.1998**
(21) Numéro de dépôt: 91402129.0
(22) Date de dépôt: 30.07.1991
(51) Int. Cl.: H01L 23/48, H01L 23/66

(54) **Procédé d'interconnexion entre un circuit intégré et un circuit support et circuit intégré adapté à ce procédé**
Verbindungsverfahren zwischen einer integrierten Schaltung und einem Schaltungsträger und an dieses Verfahren angepasste, integrierte Schaltung
Interconnection method between an integrated circuit and a circuit carrier and integrated circuit adapted to this method

(30) Priorité: 03.08.1990 FR 909968
(43) Date de publication de la demande: 05.02.1992
(73) Titulaire: THOMSON-CSF SEMICONDUCTEURS SPECIFIQUES, 75008 Paris (FR)
(72) Inventeur: Quentin, Pierre, F-92045 Paris la Défense (FR)
(74) Mandataire: Guérin, Michel

(56) Documents cités:
- EP-A- 0 436 912
- DE-A- 1 514 818
- US-A- 4 537 654
- IEEE TRANSACTIONS ON ELECTRON DEVICES. vol. ED-30, no. 1, Janvier 1983, NEW YORK US pages 16 - 20; A.GUPTA ET AL.: 'Yield considerations for ion-implanted GaAs MMIC's'
- IBM TECHNICAL DISCLOSURE BULLETIN. vol. 19, no. 4, Septembre 1976, NEW YORK US pages 1232 - 1233; S. MAGDO: 'Pyramid shaped electrical feedthrough in silicon wafers'

## Description

La présente invention concerne un procédé d'interconnexion d'un circuit intégré avec son environnement, dans le domaine des hyperfréquences. Selon ce procédé, de nombreux avantages, de fiabilité ou de reproductibilité par exemple, sont liés à la connexion des entrées/sorties d'une puce par la face arrière de celle-ci, au moyen de trous métallisés qui traversent la puce. L'invention comprend également le circuit intégré, en tant que produit muni de ses trous de connexions.

Les systèmes de connexion des entrées/sorties des circuits intégrés reposent dans la majorité des cas sur les méthodes classiques utilisant des fils ou des rubans pour réaliser les liaisons entre la puce de circuit intégré et son circuit support. Pour des productions en grandes quantités, le côut du câblage entre pour une part importante dans le côut global de la fonction électrique, même en utilisant des machines de câblage automatique. En outre, dans le domaine des circuits hyperfréquences, il est connu que les fils métalliques d'interconnexion, si courts soient-ils, présentent une inductance de l'ordre de 0,2 à 0,3 nH, quand il en faudrait moins de 0,1 nH, pour une fréquence considérée.

L'utilisation de films TAB (tape automatic bonding), de billes métalliques sur les plots de contact ou encore le montage à l'envers, c'est à dire la face active du circuit intégré contre le circuit support, sont trois méthodes connues qui assurent une interconnexion collective, mais qui par contre soit ne conviennent pas en hyperfréquences, soit nécessitent une préparation de la puce, avec impossibilité d'y avoir accès si elle est montée à l'envers.

L'invention propose de supprimer les connexions par fils ou rubans, soudés sur la face avant ou supérieure de la puce, et de ramener les plots de connexion sur la face arrière du circuit monolithique, soit du côté du substrat. Les liaisons électriques entre les composants intégrés sur le circuit monolithique et les plots en face arrière se font par des trous métallisés qui traversent la puce sur toute son épaisseur.

En outre, la face arrière qui très généralement est métallisée, est gravée pour isoler les plots de connexion, et offrir un passage vers ces plots aux pistes métalliques du circuit support.

Pour un circuit intégré muni des moyens de l'invention, tous les plots d'accès extérieur du circuit intégré sont connectés au circuit support pendant l'étape de report du circuit intégré sur le circuit support, à condition que celui-ci soit adapté en conséquence, puisque les pistes métalliques doivent être prolongées pour pénétrer sous la puce de circuit intégré.

De façon plus précise, l'invention concerne un circuit intégré hyperfréquence de type monolithique comportant un corps en matériau semiconducteur, une métallisation de masse sur une première face du corps, une région de composants intégrés sur une deuxième face du corps et sur cette deuxième face des métallisations d'accès non reliées à la métallisation de masse, caractérisé en ce qu'il comporte des trous métallisés reliant les métallisations d'accès de la deuxième face à des plots d'interconnexion situés sur la première face.

L'invention concerne également un procédé d'interconnexion d'une telle puce de circuit intégré sur un circuit support comprenant un réseau de pistes métalliques et une métallisation de fixation caractérisé en ce qu'on réalise d'abord cette puce et on la fixe ensuite sur le circuit support au moyen des métallisations de masse et de fixation de manière que les plots d'interconnexion de la première face soient en contact avec des pistes métalliques du support.

On notera qu'il est connu de l'article IEEE Transactions on Electron Devices, vol. ED-30, n°1, Janvier 1983, pages 16-20, de connecter les conducteurs de masse de la face inférieure par l'intermédiaire d'un trou métallisé. Ce document divulgue un circuit intégré selon la préambule de la revendication 1.

L'invention sera mieux comprise par la description suivante d'un exemple d'application, qui s'appuie sur les figures jointes en annexe, lesquelles représentent :
- figure 1 : en vue en plan, schéma de connexion externe d'une puce, selon l'art connu,
- figure 2 : le même type de connexion, selon l'invention
- figure 3 : vue en coupe d'une puce munie des moyens de connexion selon l'invention,
- figure 4 : vue en plan d'une puce montée sur un circuit support au moyen de trous métallisés.

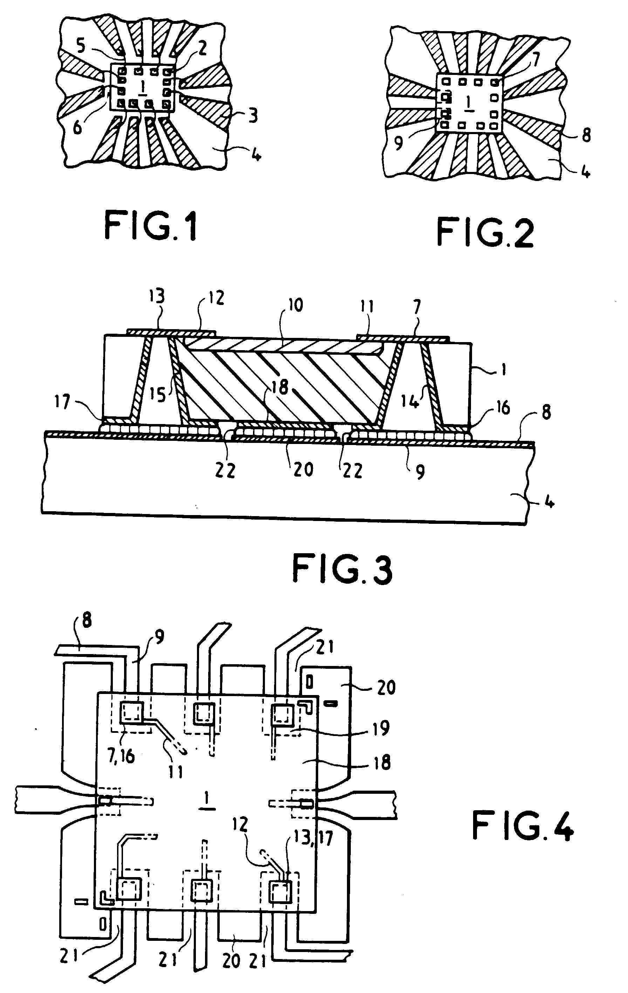

La figure 1 représente, vu de dessus, de montage classique d'une puce de circuit intégré sur un circuit support, dont seule une petite région qui entoure la puce est représentée.

Une puce de circuit intégré 1 est munie, sur sa face supérieure, ou encore face active, de plots de connexion métalliques 2. Les voies d'accès extérieures, entrées ou sorties, polarisations ... etc, sont constituées par des pistes métalliques 3 gravées sur un support isolant 4. Pour réunir le circuit intégré 1 à son environnement, il faut d'abord fixer la puce 1 sur le support 4, par brasure, puis souder des fils ou rubans métalliques 5 sur les plots 2 et sur les extrêmités des pistes métalliques 3 qui viennent au plus près de la puce 1, mais ne pénètrent pas sous la puce, sinon elles seraient court-circuitées. C'est pourquoi un intervalle 6 entre puce et extrémité des pistes est nécessaire. Cette opération de "couture" des fils est longue et délicate, même avec des machines automatiques. En effet, surtout en hyperfréquences, il faut que les fils métalliques 5 soient les plus courts possibles, en raison de l'inductance parasite qu'ils apportent.

Deux cas se présentent : la puce 1 est brasée sur la face du support isolant 4, ou bien elle est fixée au fond d'une dépression formée dans ce support 4. Si elle est en surface du support 4, il y a une différence de niveau entre le plan des plots 2 sur la puce 1 et le plan des pistes 3 sur le support 4: les fils de connexions 5 doivent faire une boucle pour ne pas toucher le bord de la puce 1, et cette boucle augmente l'inductance parasite. Pour éviter cette différence de niveau, on peut créer une dépression dans laquelle la puce prend place : les connexions sont alors établies au moyen de rubans ou de poutres métalliques planes, qui remplacent les fils 5 courbes. Mais il est évident que ces opérations augmentent les côuts de montage et de câblage.

L'invention apporte une simplification importante en proposant de fixer une puce de circuit intégré 1 à l'endroit sur un circuit support -ce qui est classique- mais en prenant les contacts électriques sur la face arrière de la puce, qui est traversée sur toute son épaisseur par des trous métallisés, de telle sorte que la face arrière, côté substrat, de la puce devient simultanément la face de fixation de la puce, par brasure, et la face d'interconnexion.

La figure 2 représente un ensemble équivalent à la figure 1, mais interconnecté selon l'invention. La puce de circuit intégré 1 est percée de trous métallisés sur lesquels on reviendra ultérieurement, et qui ne sont pas visibles ici car ils sont cachés par un opercule métallique 7, qui sert éventuellement à tester la puce. Sur le support isolant 4, les pistes métalliques 8 sont légèrement modifiées par rapport aux pistes 3 de l'art connu ; elles penètrent sous la puce, tel que représenté en pointillé en 9 pour deux d'entre elles, afin de prendre les contacts sur les trous métallisés.

La figure 3 donne une vue en coupe agrandie, qui permet de mieux détailler la puce de circuit intégré. A cette fin, les proportions ne sont pas respectées.

Le circuit intégré 1 comprend un substrat qui supporte une région 10 dans laquelle sont réalisés les composants actifs et passifs du circuit intégré. Ces composants et les différentes couches de matériaux de la région 10 ne sont pas représentés, car ils ne sont pas nécessaires à l'exposé de l'invention , mais ils comportent des métallisations d'accès, dont deux sont représentées. La métallisation 11 conduit au plot métallique 7, et la métallisation 12 conduit au plot métallique 13. Chacun des plots métalliques 7 ou 13 de la face supérieure, ou active, du circuit intégré est réuni par l'intermédiaire d'un trou métallisé, 14 ou 15, avec une plage métallique 16 ou 17 respectivement, située sur la face inférieure, ou substrat, du circuit intégré. Ainsi, le plan des connexions d'accès extérieur est déplacé de la face supérieure à la face inférieure de la puce de circuit intégré. Cette dernière porte une métallisation de plan de masse 18, qui est utilisée pour braser la puce 1 sur son circuit support. Mais la présence des plages métalliques 16 et 17 en face arrière de la puce 1 nécessite une gravure du plan de masse 18, qui est montrée en figure 4.

Sur cette figure, il ressort mieux que la métallisation de plan de masse 18 a un pourtour crénelé, des plages isolantes 19 ayant été gravées pour créer les plages 16 et 17 sur les bords de la puce 1. Cette figure montre également que le circuit support 4 (non représenté) comporte une métallisation 20 pour accueillir le circuit intégré, et l'y braser par l'intermédiaire de son plan de masse 18. Cette métallisation 20 comprend elle-aussi des créneaux 21, correspondant aux créneaux 19, et destinés à laisser les pistes conductrices 8 + 9 atteindre les plages métalliques 16,17.

La superposition du circuit intégré sur son circuit support explique que les plots métalliques 7 et 16, 13 et 17, ou les créneaux 19 et 21 se superposent.

Les deux opérations de fixation du circuit intégré sur son support et de raccordement des plots d'accès du circuit intégré au réseau d'interconnexion porté par le support se font en une seule manipulation de brasure collective. Les plages 16,17 sont brasées sur les pistes conductrices 9, et le plan de masse 18 est brasé sur la métallisation 20, simultanément, soit au moyen d'une recharge en or-germanium des différentes métallisations en présence, soit au moyen d'une préforme de soudure tendre. Cette seconde solution est extrêmement intéressante, car elle est plus rapide et plus économique que la première. Bien que l'opération de brasure doive respecter l'isolement électrique entre le plan de masse et les plages 16,17 d'entrées-sorties, il suffit de mettre en place une préforme de soudure tendre assez fine pour que, au cours de sa fusion, elle se divise en fragments 22, qui, par les forces de capillarité, prennent les contours des plages métalliques à braser : ainsi, une seule préforme donne plusieurs brasures 22, isolées entre elles.

Les trous métallisés 14,15 sont généralement disposés sur le pourtour de la puce 1, par commodité pour le tracé du réseau de pistes conductrices 8+9 sur le circuit support. Cependant, un ou plusieurs trous métallisés peuvent se trouver dans la région centrale de la puce 1, soit pour prendre un contact de masse, ce qui est connu, soit pour établir une liaison extérieure ce qui suppose que les crénaux correspondants 19 + 21 soient approfondis en conséquence.

Les avantages apportés par l'invention sont intéressants, surtout en hyperfréquences :
- Diminution des côuts de montage puisque le câblage se fait en même temps que l'opération de report. De plus il s'agit d'une technique collective.
- Augmentation de la fiabilité par la suppression des fils de câblage et la réduction d'un facteur 2 du nombre de contacts. Diminution des contraintes sur la face supérieure de la puce de circuit intégré.
- Réduction de l'inductance parasite d'interconnexion d'un facteur 6; elle est ramenée à quelques dizaines de nH par trou métallisé. Possibilité de compensation par capacité localisée en face avant et en face arrière de la puce.
- Reproductibilité de l'inductance d'interconnexion réduisant la dispersion de phase due au câblage.

L'invention, qui est d'usage général, avec des dispositifs semiconducteurs en Si ou en matériaux III-V, est surtout appliquée dans le domaine des hyperfréquences. Elle est précisée par les revendications suivantes.

## Revendications

1. Circuit intégré hyperfréquence de type monolithique comportant un corps (1) en matériau semiconducteur, une métallisation de masse (18) sur une première face du corps, une région de composants intégrés (10) sur une deuxième face du corps et sur cette deuxième face des métallisations d'accès (7, 13) non reliées à la métallisation de masse, caractérisé en ce qu'il comporte des trous métallisés (14, 15) reliant les métallisations d'accès de la deuxième face à des plots d'interconnexion (16, 17) situés sur la première face.

2. Procédé d'interconnexion d'une puce de circuit intégré (1) sur un circuit support comprenant un réseau de pistes métalliques (8, 9) et une métallisation de fixation (20), caractérisé en ce qu'on réalise d'abord une puce selon la revendication 1 et on fixe la puce sur le circuit support au moyen des métallisations de masse et de fixation (18, 20) de manière que les plots d'interconnexion (16, 17) de la première face soient en contact avec les pistes métalliques du support (8, 9).

3. Procédé d'interconnexion d'une puce de circuit intégré selon la revendication 2, caractérisé en ce que le circuit intégré (1) est brasé (22) par sa métallisation de masse sur une métallisation de fixation (20) du circuit support.

4. Procédé d'interconnexion d'une puce selon l'une des revendications 2 ou 3, caractérisé en ce que chaque plage métallique (16, 17) sur la première face du circuit intégré est brasée sur une extrémité (9) de piste métallique du circuit support.

5. Procédé d'interconnexion d'une puce selon l'une des revendications 2 à 4, caractérisé en ce que les plots d'interconnexion (16, 17) de la métallisation de masse (18) sont réalisés par une étape de gravure d'une couche métallique recouvrant la première face.

## Patentansprüche

1. Integrierte Höchstfrequenzschaltung vom monolithischen Typ mit einem Körper (1) aus Halbleitermaterial, einer Massemetallisierung (18) auf einer ersten Fläche des Körpers, einem Bereich von integrierten Bauteilen (10) auf einer zweiten Fläche des Körpers und mit Zugangsmetallisierungen (7, 13) auf dieser zweiten Fläche, die nicht mit der Massemetallisierung verbunden sind, dadurch gekennzeichnet, daß sie metallisierte Löcher (14, 15) aufweist, welche die Zugangsmetallisierungen den zweiten Fläche mit Anschlußflecken (16, 17) verbinden, die auf der ersten Fläche liegen.

2. Verfahren zum Verbinden eines integrierten Schaltungschips auf einer Trägerschaltung, die ein Netz von Metallbahnen (8, 9) und eine Befestigungsmetallisierung (20) aufweist, dadurch gekennzeichnet, daß man zunächst einen Chip gemäß Anspruch 1 herstellt und den Chip auf der Trägerschaltung mittels der Masse- und Befestigungsmetallisierungen (18, 20) derart befestigt, daß die Anschlußflecken (16, 17) der ersten Fläche mit den Metallbahnen (8, 9) des Trägers in Kontakt stehen.

3. Verfahren zum Verbinden eines integrierten Schaltungschips nach Anspruch 2, dadurch gekennzeichnet, daß die integrierte Schaltung (1) mit ihrer Massemetallisierung auf eine Befestigungsmetallisierung (20) der Trägerschaltung aufgelötet (22) ist.

4. Verfahren zum Verbinden eines Chips nach einem der Ansprüche 2 oder 3, dadurch gekennzeichnet, daß jeder metallische Bereich (16, 17) auf der ersten Fläche der integrierten Schaltung auf ein Ende (9) einer Metallbahn der Trägerschaltung aufgelötet ist.

5. Verfahren zum Verbinden eines Chips nach einem der Ansprüche 2 bis 4, dadurch gekennzeichnet, daß die Anschlußflecken (16, 17) der Massemetallisierung (18) durch einen Schritt des Ätzens einer die erste Fläche bedeckenden Metallschicht gebildet sind.

## Claims

1. Microwave integrated circuit of monolithic type including a body (1) made of semiconducting material, an earth metallization (18) on a first face of the body, a region of integrated components (10) on a second face of the body and, on this second face, access metallizations (7, 13) which are not linked to the earth metallization, characterized in that it includes metallized holes (14, 15) linking the access metallizations of the second face to interconnection pads (16, 17) situated on the first face.

2. Method of interconnecting an integrated-circuit chip (1) on a carrier circuit comprising a network of metal tracks (8, 9) and a bonding metallization (20), characterized in that a chip is first made in accordance with Claim 1 and the chip is bonded to the carrier circuit by means of the earth and bonding metallizations (18, 20) in such a way that the interconnection pads (16, 17) of the first face are in contact with the metal tracks of the carrier (8, 9).

3. Method of interconnecting an integrated-circuit chip according to Claim 2, characterized in that the integrated circuit (1) is soldered (22) via its earth metallization to a bonding metallization (20) of the carrier circuit.

4. Method of interconnecting a chip according to one of Claims 2 and 3, characterized in that each metal land (16, 17) on the first face of the integrated circuit is soldered to an end (9) of a metal track of the carrier circuit.

5. Method of interconnecting a chip according to one of Claims 2 to 4, characterized in that the interconnection pads (16, 17) of the earth metallization (18) are made by a step of etching a metallic layer covering the first face.
